# EUROPEAN PATENT APPLICATION

(11) **EP 1 928 023 A2**
(43) Date of publication of application: **04.06.2008**
(21) Application number: 06024955.4
(22) Date of filing: 01.12.2006
(51) Int. Cl.: H01L 23/467, H05K 7/20

(54) **Cooling apparatus for memory modules**

(71) Applicant: Richard & Ronald International Company Ltd., Lu Jou City (TW)
(72) Inventor: Tsai, Yung Chang, Lu Shou City (TW)
(74) Representative: Casalonga, Axel

(57) **Abstract**

A cooling apparatus for memory modules includes a pair of heat sinks each has at least one surface forming an air passage to direct airflow. The air passage has at least one inlet and one outlet. An air fan is provided close to the inlet. The heat sinks are bonded to two sides of a memory module. The air fan generate airflow which is directed inwards through the inlet and discharged through the outlet to rapidly dispel accumulating heat generated by the memory module during operation and adsorbed by the heat sinks.

## Description

The present invention relates to a cooling apparatus for memory modules and particularly to a cooling apparatus for DRAM or SDRAM modules that rapidly dispels accumulating heat of the memory modules during operation through forced airflow and an air directing means.

Dynamic random access memory (DRAM) and Synchronous dynamic random access memory (SDRAM) are the commonly used memory in computers at present. They often are deployed by coupling a number of them and installed on a circuit board to form a module. The module has pins to be inserted into insertion slots of a computer motherboard.

To meet the requirements of different operation speeds, the computer may have different number of memory modules or memory modules of higher clock. The memory modules often are located in the central processor of the computer that generates heat during operation. When more memory modules or higher time pulse frequency are used, more heat is generated. This affects the operation efficiency of the memory and shortens the life span thereof. To overcome this problem, one of the techniques being adopted at present is directly attaching an aluminum or copper heat sink to the surface of the memory, or adding a dedicated and external heat sink on the memory to enhance cooling effect of the memory and maintain operation stability.

The dedicated heat sink for the memory usually is made from a high conductive material such as copper and aluminum and formed in a thin sheet of a large area, and is directly bonded to two sides of the memory module through a thermally-conductive adhesive. By means of the conductive area and heat transfer characteristics of the heat sink accumulating heat on the memory module during operation can be dispelled naturally. While the aforesaid approach can achieve cooling effect in theory, the actual cooling efficiency is not desirable. This is especially true in the environment of animation or high speed processing. Natural cooling approach often cannot meet requirements. To remedy this problem, another approach similar to cooling CPU is being proposed in the industry. This approach provides forced cooling through an air fan to dispel the accumulated heat of the memory module. Reference can be found in R.O.C. patent publication Nos. 534373 and 200411358. These two techniques install an air fan on the memory module to dispel the heat generated by the memory module. But due to interference of the peripheral devices the cooling airflow generated by the air fan is disturbed and cannot be effectively directed to the heat generating source. Hence cooling effect suffers. Moreover, the air fan is installed on a rack which is mounted on the insertion slot of the memory module. A plurality of memory modules are coupled in a larger space to accommodate the air fan to facilitate forced cooling in a thin size memory module environment. However, in this approach the air fan is not directed to a selected memory module to perform cooling. As the individual memory modules have different cooling efficiency by receiving different amount of airflow, cooling efficiency is only slightly better than natural heat dispelling of the heat sink.

The primary object of the present invention is to provide a cooling apparatus for memory modules that has an air directing means to channel cooling airflow generated by an air fan directly to the memory modules to effectively dispel accumulating heat of the memory modules during operation.

Another object of the present invention is to provide a cooling apparatus for memory modules that provides an air fan for each memory module to effectively dispel heat according to the individual module.

To achieve the aforesaid objects the cooling apparatus according to the invention includes a pair of heat sinks bonding to two opposite sides of a memory module. Each heat sink has at least one surface forming an air passage to direct airflow. The air passage has at least one inlet and one outlet, and an air fan located close to the inlet.

By means of the cooling apparatus thus formed, cooling airflow generated by the air fan is channeled inwards through the inlet and discharged through the outlet. Hence the cooling airflow passes through all the areas of the heat sinks to directly perform heat exchange for accumulating heat adsorbed by the memory modules during operation, then dispel the heat. As a result, the temperature of the memory modules can be lowered quickly and effectively to overcome the disadvantages of the conventional techniques that do not have a higher cooling efficiency due to airflow disturbance.

In the cooling apparatus mentioned above the air fan is provided to mate each memory module. Hence the cooling airflow is not dispersed and can be channeled directly to each memory module. Coupled with the air passage of the heat sinks, it can lower the temperature rapidly and effectively. Thus the problems of the conventional techniques that have one air fan to cool a plurality of memory modules and result in a lower cooling efficiency can be overcome.

In one aspect of the invention, each of the heat sinks has at least one coupling structure to be coupled with another heat sink on two sides of the memory module. The coupling structure may be latch elements formed on two sides of each heat sink. The latch elements preferably include a male latch element on one side and a female latch element on another side engageable with the male latch element.

In another aspect of the invention, the air fan can be mounted onto at least one of the heat sinks through a holding rack and positioned at the inlet of the air passage, and located on one side of a upper edge of the heat sinks or in the middle of the upper edge of the heat sinks.

In yet another aspect of the invention, a pair of guarding panels may be provided to attach to outer sides of the heat sinks. The air fan may be installed on a holding rack mounting onto an upper edge of the guarding panels. The coupling structure previously discussed may be located on two sides of each guarding panel, and the two guarding panels can be coupled on two opposite outer sides of the memory module.

The foregoing, as well as additional objects, features and advantages of the invention will be more readily apparent from the following detailed description, which proceeds with reference to the accompanying drawings.
FIG. 1 is a schematic front view of a first embodiment of the cooling apparatus for memory modules of the invention with the air fan holding rack fastened to the outer side of the heat sink;
FIG. 2 is a schematic side view according to FIG. 1;
FIG. 3 is a schematic side view of an embodiment of the invention with the coupling structure in a coupling condition;
FIG. 4 is a schematic front view of the first embodiment of the invention with the air fan holding rack formed integrally with the heat sinks;
FIG. 5 is a schematic front view of a second embodiment of the cooling apparatus of the invention;
FIG. 6 is a schematic side view according to FIG. 5;
FIG. 7 is a schematic side view of a third embodiment of the invention with the air fan holding rack coupling with the guarding panels;
FIG. 8 is a schematic side view of the third embodiment of the invention with the air fan holding rack formed integrally with the guarding panels; and
FIG. 9 is a schematic front view of a fourth embodiment of the invention with the air fan coupled externally on the heat sink through an air duct.

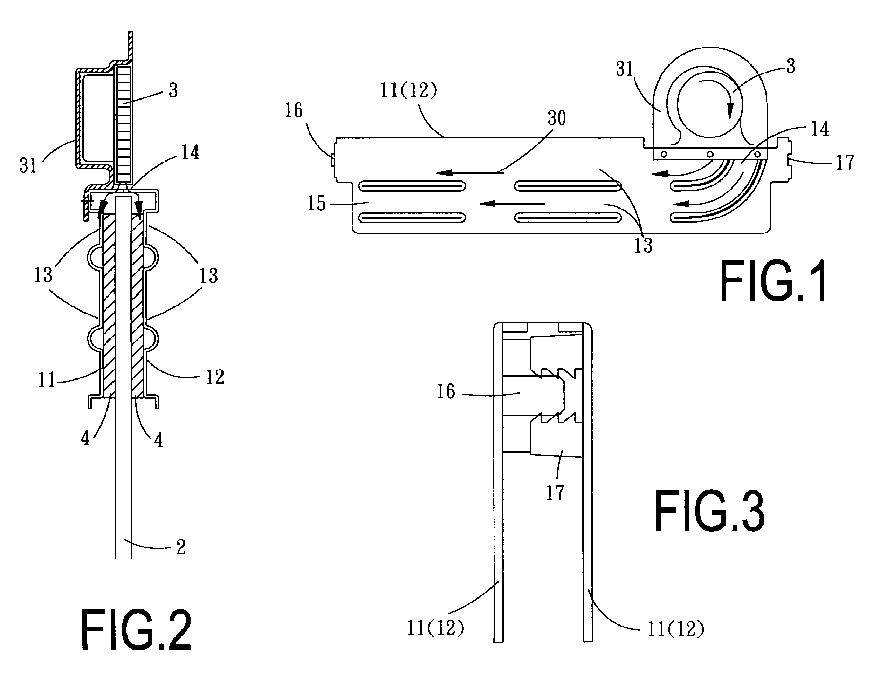

Refer to FIG. 1 and 2 for a first embodiment of the cooling apparatus for memory modules of the invention. It includes a pair of heat sinks 11 and 12 that are bonded to two sides of a memory module 2 through heat conductive adhesive 4. Each of the heat sinks 11 and 12 has at least one surface forming an air passage 13 to direct airflow. The air passage 13 has at least one inlet 14 and one outlet 15. An air fan 3 is provided close to the inlet 14.

In the first embodiment set forth above, each of the heat sinks 11 and 12 has at least one coupling structure to be coupled with another heat sink on the two sides of the memory module. The coupling structure preferably includes latch elements 16 and 17 on two sides of each of the heat sinks 11 and 12. The latch element 16 may be a male latch element while the other latch element 17 may be a female latch element as shown in FIG. 3.

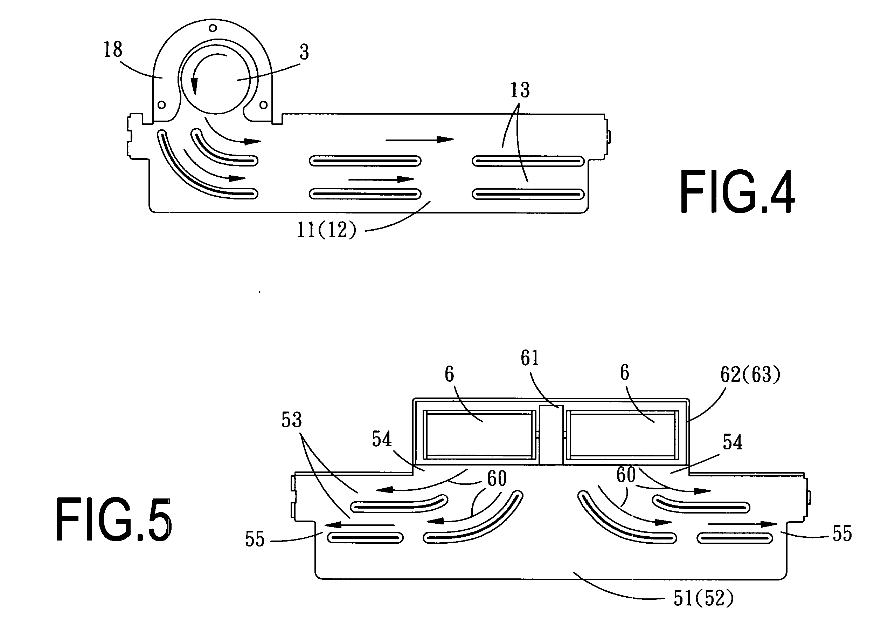

In the first embodiment mentioned above, the air fan 3 may be mounted onto at least one of the heat sinks 11 and 12 through a holding rack 31 at the inlet 14 as shown in FIGS. 1 and 2. In the first embodiment the holding rack 31 is installed at the inlet 14 as an external element as shown in FIG. 1. In another embodiment the holding rack 18 is integrally formed with the heat sinks 11 and 12 at the inlet 14 as shown in FIG. 4. Thus cooling airflow 30 generated by the air fan 3 can be directed through the inlet 14 to the air passage 13 and discharged through the outlet 15.

In the first embodiment the inlet 14 is located on one side of a upper edge of the heat sinks 11 and 12 as shown in FIGS. 1 and 4.

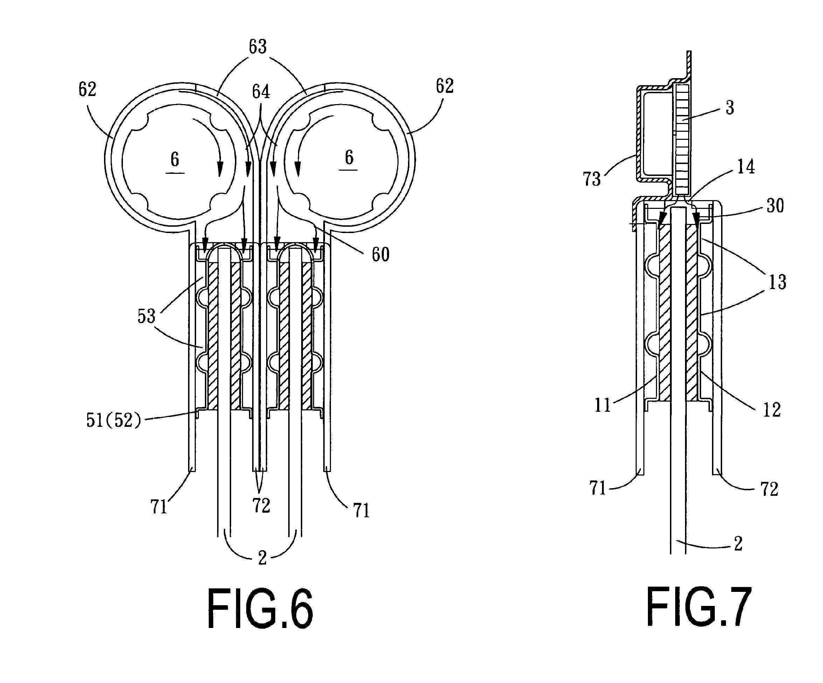

Refer to FIG. 5 for a second embodiment of the invention. The air passage 53 of the heat sinks 51 and 52 has an inlet 54 located in the middle of the upper edge of the heat sinks 51 and 52. The air passage 53 is divided into two opposite paths below the inlet 54 in a symmetrical fashion on a left side and a right side towards outlets 55. For such an air passage 53, at least two air fans 6 are provided and located on two sides above the inlet 54. And at least one motor 61 is provided to control the two air fans 6 to generate cooling airflow 60 through the inlet 54 to the air passage 53 and discharged through the outlets 55. In the second embodiment set forth above, the air fans 6 are located on one side above the memory module 2 in a bias manner, and are encased by a pair of holding racks 62 and 63 on the left side and right side to form an air directing channel 64 to direct the cooling air flow 60 to the inlet 54 as shown in FIG. 6. With the air fans installed in such a way the memory module 2 can be inserted in a compact manner and still enjoy the benefit of forced cooling.

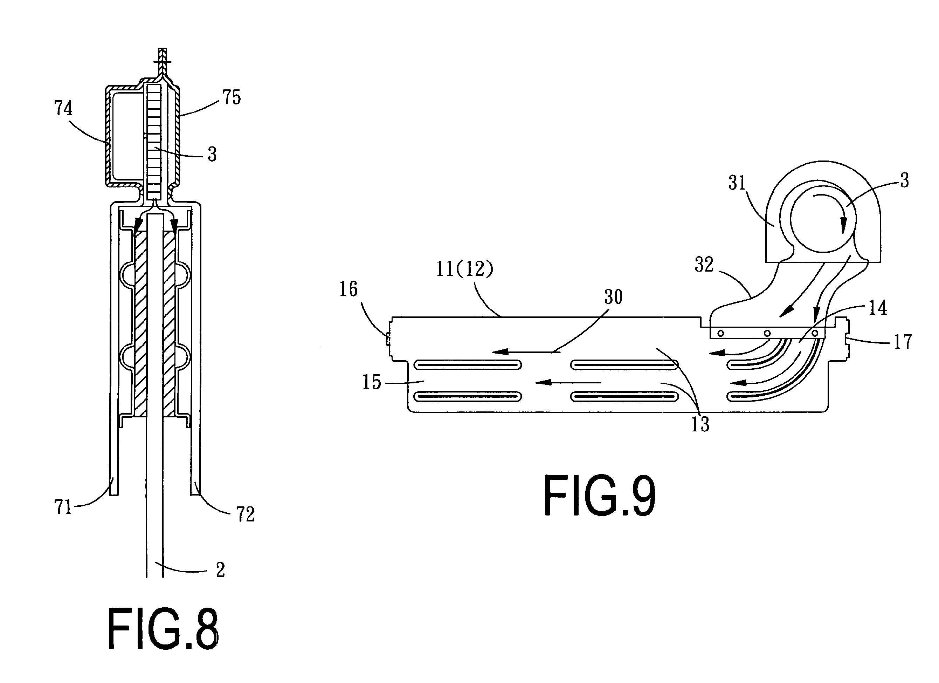

Refer to FIG. 7 for a third embodiment of the invention. It includes a pair of heat sinks and an air fan as the first and second embodiments do. In addition, a pair of guarding panels 71 and 72 are provided and bonded to opposite outer sides of the heat sinks 11 and 12 to protect the heat sinks 11 and 12, and also form a flat and smooth profile. At least one of the guarding panels 71 and 72 has an upper edge fastened to a holding rack 73 to hold the air fan 3 at the inlet 14 of the air passage 13. Thus the cooling airflow 30 generated by the air fan can be directed through the inlet 14. The holding rack 73 may be an external element installed on the guarding panels 71 and 72 as shown in FIG. 7. Or a pair of holding racks 74 and 75 may also be integrally formed with the guarding panels 71 and 72 as shown in FIG. 8.

Compared with the first and second embodiments, in the third embodiment the coupling structure are located on two sides of the guarding panels 71 and 72 so that the two guarding panels can be coupled on two outer sides of the memory module.

Refer to FIG. 9 for a fourth embodiment of the invention. While in the first embodiment shown in FIG. 1 the holding rack 31 of the air fan 3 is directly located on the heat sinks 11 and 12, in the fourth embodiment the air fan 3 is remote from the heat sinks 11 and 12, and is connected to the heat sinks 11 and 12 through an air duct 32 so that the cooling airflow delivered from the air fan 3 is transported through the air duct 32 to the heat sinks 11 and 12 to perform heat exchange.

In short, the embodiments previously discussed have a pair of heat sinks bonding to two sides of a memory module with an air passage formed on the surface of the heat sinks to channel airflow. An air fan is located on the inlet of the air passage to allow the cooling airflow to pass through the air passage under desired directing so that the accumulating heat generated by the memory during operation and adsorbed by the heat sinks is discharged through the outlet. Thereby the temperature of the memory module can be lowered rapidly and effectively.

While the preferred embodiment of the invention has been set forth for the purpose of disclosure, modifications of the disclosed embodiment of the invention as well as other embodiment thereof may occur to those skilled in the art. Accordingly, the appended claims are intended to cover all embodiments which do not depart from the spirit and scope of the invention.

## Claims

1. A cooling apparatus for memory modules, comprising:
a pair of heat sinks bonding to two opposite sides of a memory module each having at least one surface forming an air passage to direct airflow, the air passage having at least one inlet and one outlet; and
an air fan located close to the inlet to generate cooling airflow which is directed inwards through the inlet and discharged through the outlet to rapidly dispel accumulating heat generated by the memory module during operation and adsorbed by the heat sinks.

2. The cooling apparatus for memory modules of claim 1, wherein each of the heat sinks has two sides which have a coupling structure consisting of at least a latch element to couple with another heat sink on the two sides of the memory module.

3. The cooling apparatus for memory modules of claim 1, wherein the air fan is installed on at least one of the heat sinks through a holding rack at the inlet.

4. The cooling apparatus for memory modules of claim 3, wherein the holding rack is an external element bonding to the heat sinks.

5. The cooling apparatus for memory modules of claim 3, wherein the holding rack is integrally formed on the heat sinks.

6. The cooling apparatus for memory modules of claim 1, wherein the air fan is installed on at least one of the heat sinks through an air duct at the inlet.

7. The cooling apparatus for memory modules of claim 1, wherein the inlet is located on one side of an upper edge of the heat sinks.

8. The cooling apparatus for memory modules of claim 1, wherein the inlet is located in the middle of an upper edge of the heat sinks.

9. A cooling apparatus for memory modules, comprising:
a pair of heat sinks bonding to two opposite sides of a memory module each having at least one surface forming an air passage to direct airflow, the air passage having at least one inlet and one outlet;
a pair of guarding panels bonding to opposite outer sides of the heat sinks, at least one of the guarding panels having a holding rack on a upper edge thereof; and
an air fan mounted onto the holding rack close to the inlet to generate cooling airflow which is directed inwards through the inlet and discharged through the outlet to rapidly dispel accumulating heat generated by the memory module during operation and adsorbed by the heat sinks.

10. The cooling apparatus for memory modules of claim 9, wherein each of the guarding panels has at least one coupling structure to couple with another guarding panel on two outer sides of the memory module.
